# EUROPEAN PATENT APPLICATION

(11) **EP 0 674 476 A2**
(43) Date of publication of application: **27.09.1995**
(21) Application number: 95301669.8
(22) Date of filing: 14.03.1995
(51) Int. Cl.: H05K 9/00, H03H 1/00

(54) **Shielding device**

(30) Priority: 25.03.1994 FI 941407
(71) Applicant: LK-PRODUCTS OY, SF-90440 Kempele (FI)
(72) Inventor: Raatikainen, Seppo, SF-90450 Kempele (FI)
(74) Representative: Frain, Timothy John

(57) **Abstract**

The present invention relates to grounding a shielding device comprising a conductive housing metal box for a filter, particularly when the filter is mounted on a circuit board using surface mounting technique. As taught by the invention, protrusions (5) have been formed on a wall (4) of the conductive housing (1) of the box on which the box is grounded primarily by means of a soldering connection. The protrusions (5) can be so formed that they define as accurately as possible the level (A-A) in order to achieve good and uniform grounding in the surface mounting. With the design of the invention, ± 0.05 mm planarity requirement can be met. In a primary embodiment, the wall of the shell (1) is of silver-coated aluminium, the thickness thereof being of the order 0.3 mm. The bumps are formed by embossing, the nominal height thereof being 0.3 mm.

## Description

The present invention relates to a housing for electronic components, and particularly to grounding a conductive housing mounted on a circuit board.

Due to the sensitivity of many components to radio frequency interference (rfi), it is known to encapsulate them in grounded conductive housings to shield them from RFI. A particularly sensitive class of devices is filters.

Filters needed in electronic apparatus are produced using a wide variety of techniques. For example, known filter types in the art are helix type or those produced using a ceramic technique. It is also customary that a filter is encapsulated in a conductive housing, typically a metal box, and that the box is grounded when the filter is mounted in place, for instance on a circuit board commonly used in assembling electronic apparatus. Filters are often highly sensitive electronic circuits and hence, any differences in grounding the box affects the functioning of the filter.

A common assembly technique for circuit boards and electronic apparatus is the so-called surface mounting technique, i.e. SMD technique. In this technique a circuit board or other base board on which components are mounted is not provided with mounting holes for component leads, but instead, mounting is accomplished by the leads or other points of a component to be connected being placed against and on connection areas of a circuit board or equivalent. Fixing to the circuit board is then made by soldering or using ome other connection method. Soldering is a normally used method. Accordingly, versions appropriate for surface mounting have been developed from metal-boxed filters, and at the same time, endeavours have been made to seek designs useful in surface mounting in order to ground a box. A filter example and a surface mounting version with a grounding design developed therefrom are examined below as an example of the state of art.

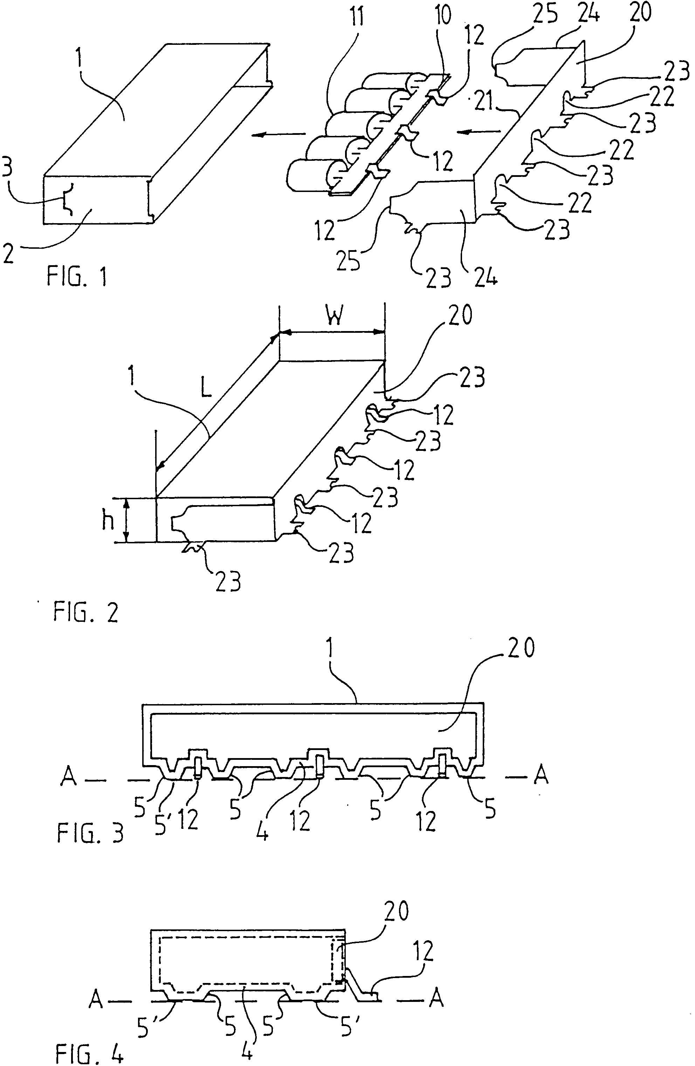

An exemplary state of the art filter is presented in Fig. 1 in an exploded view. The filter can be e.g. a duplex filter for a radio phone implemented as a helix type filter, operating e.g. in 400 or 900 MHz frequency range. The filter components 11 are connected to a circuit board 10 from which leads 12 extend. The circuit board having the components is joined to a grounded base 20 made of a metal, such as brass, and provided with apertures 22 for connecting leads 12, and in which base grounding lugs 23 have been formed. The grounded base 20, to which a circuit board 10 with components 11 has been joined, is disposed in a metal shell 1 to which it is soldered on the edges 21. In order to have grounding points else where besides the front edge of the box, the grounded base 20 is provided with bent extensions 24 having one or several grounding lugs 23 and set against the ends 2 of the shell. The ends 25 of extensions 24 extend into apertures 3 in the end sides 2 of the shell and are soldered therein.

Fig. 2 presents an exemplary filter as assembled. As can be seen from the figure, the shell is intended to be mounted on a side and soldered to the connection areas of a circuit board using leads 12 and grounding lugs 23. The dimensions of the filter can be, for instance, I = 40 mm, w = 12 mm, and h = 8 mm, so it is quite large for a component.

The above described filter has the following drawbacks. For surface mounting, it is desirable for the leads 12 and the lugs 23 to be in one and the same plane as accurately as possible in the direction of the surface to be set against the circuit board of the box and in a plane therebelow so that soldering would properly succeed, that the result would be good and uniform and that an appropriate insulating air space would be left between the box and the circuit board. For that reason, the leads 12 and/or lugs 23 have to be compressed between two planar surfaces, in order for them to meet the planarity requirement.

The present invention provides a shielding device for an electronic component comprising a conductive housing including means for facilitating electronically coupling to an electronic component disposed therein, and grounding means for coupling the conductive housing to ground, characterised in that the grounding means comprise protrusions formed in a wall of the conductive housing. This has an advantage that the state of art drawbacks described above can be ameliorated and the surface area taken up by such a shielding device is reduced relative to known shielding devices. This enables a higher density of components to be placed on a circuit board. Additionally, grounding connections can be dispersed almost any where over the area of a wall and thus a substantially uniform grounding of the shielding device can be obtained.

The height of the protrusions to be embossed can be so selected that the box can be detached away from the surface of the circuit board so that wiring can be placed thereunder more securely and more easily.

Furthermore, the protrusions can be asymetrically dispersed which assists orientating the devices on circuit boards and aids automated assembling.

In a preferred embodiment protrusions have been so formed that outermost points thereof are adapted to be substantially co-planar with portions of coupling means external to the housing.

An embodiment of the invention is now described in detail by way of example only, and with reference to the accompanying drawings, of which:
Fig. 1 presents as an exploded view a state of art surface mountable metal box filter;
Fig. 2 presents the filter of Fig. 1 in assembled form;
Fig. 3 presents schematically an embodiment of a filter box in accordance with the present invention in front view;
Fig. 4 shows the box of Fig. 3 in elevational view,
Figs. 5(a) and 5(b) present schematically a state of art filter box and a filter box in accordance with the invention respectively in top view; and
Fig. 6 presents a potential formation and dimensioning of a grounding bump, as well as the environment thereof in a situation in which a filter has been positioned on a circuit board for soldering.

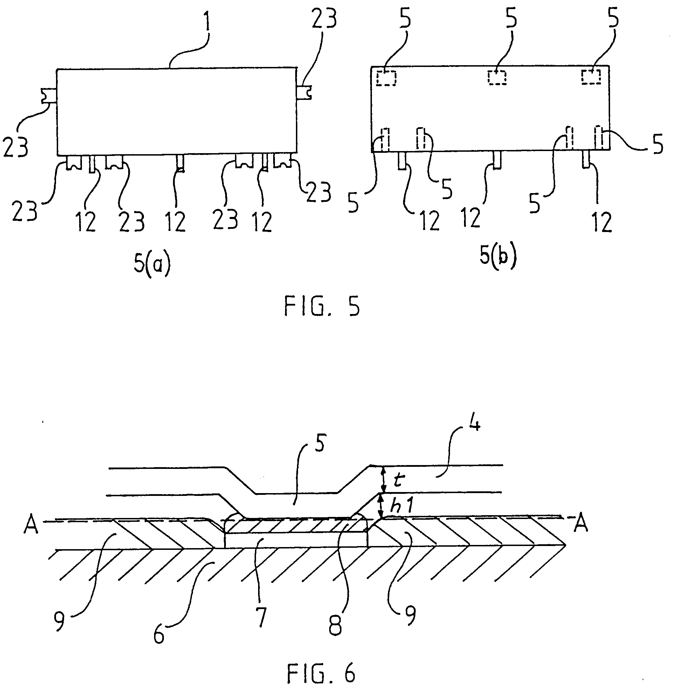

A state of the art design presented in Figs. 1 and 2 is examined above in the introductory part of the description. Fig. 3 presents schematically an embodiment of a box in accordance with the invention viewed from the front on the side of the grounding base 20. It shows that bumps 5 have been formed on a wall 4 of a shell 1 placed against the circuit board, the outermost points 5' thereof together with the lower surfaces of the connection leads 12 of the filter defining plane A-A. Fig. 4 shows the same box in side elevational view, the inner surfaces of the side and rear walls of shell 1 and the grounding base 20 being depicted with broken lines therein. The most common configuration of the shell 1 is, as in the present example, usually a parallelepiped open on one face and made from an integral metal sheet of relatively uniform thickness.

Fig. 5(a) shows schematically in top view a state of the art box as in Figs. 1 and 2, provided with grounding lugs 23 projecting from the box and formed by the aid of the grounding base bent from the front side to the end sides of the box shell 1, and connecting leads 12 of the filter. Fig. 5(b) presents schematically a design in accordance with the present invention. In this design, the contours of the bumps 5 formed in the wall of shell 1 facing the circuit board are indicated as broken lines. In the case shown in Figure 5(b) the grounding bumps have been positioned proximal to the box edges, but they may of course be placed where ever need be in the side wall 4.

Fig. 6 presents a potential dimensioning for a grounding bump 5. In the present instance, the thickness t of the shell wall 4 is 0.3 mm. The shell has been made of silver-coated aluminium which can be soldered when assembling electronic apparatus with conventional solders. The height h1 of a bump 5 produced in the wall is 0.3 mm. Fig. 6 shows schematically also a circuit board 6, a ground connection area 7 thereon, soldering paste 8 deposited e.g. by printing it on the connection area, and a soldering mask 9. The thickness of a lead 12 of a circuit board is typically about 0.050 mm, the thickness of a deposited solder paste layer being of the order 0.100 to 0.150 mm, and the thickness of a soldering mask typically about 0.100 mm to 0.200 mm.

The bumps can be produced for instance by embossing with the aid of an embossing tool or an equivalent cushion. In an instance in which the shell wall is of aluminium, embossing is a most adept way of embodiment. The bump height 0.3 mm mentioned above and the even surface thereof are merely examples. The bump may equally be arcuate in surface and the height of the bumps may vary as need be within the limits set by the production method and materials used.

The filter type and the structure of the filter examined above are also only examples of potential application targets of the invention, and the invention is in no way intended to concern only them. The shape of the shell is neither confined to a parallelepiped open on one face as primarily described above; instead, the invention can be applied to highly different shell shapes. The invention may vary within the scope defined by the annexed claims. For example, the box may be fabricated from an electrically conductive material other than metal. Optionally, the box may be fabricated from an insulating material having an electrically conductive layer or coating applied to its surfaces.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during prosecution of this application or of any such further application derived therefrom.

## Claims

1. A shielding device for an electronic component comprising a conductive housing (1) including means for facilitating electronically coupling to an electronic component disposed therein, and grounding means for coupling the conductive housing to ground, characterised in that the grounding means comprise protrusions (5) formed in a wall (4) of the conductive housing (1).

2. A shielding device according to claim 1, wherein the protrusions (5) have been so formed that outermost points (5') thereof are adapted to be substantially co-planar (A-A) with portions of coupling means (12) external to the housing (1).

3. A shielding device according to claim 1 or 2, wherein the protrusions (5) are formable by embossing.

4. A shielding device according to any one of the preceding claims, wherein the housing (1) is of silver-coated aluminium.

5. A shielding device according to any of claims 2 to 4, wherein the coupling means (12) comprise conductive leads.

6. A shielding device according to any one of the preceding claims, wherein the thickness of the wall (4) of the housing (1) is in the range 0.2 to 0.4 mm.

7. A shielding device according to any one of the preceding claims, wherein the height of the protrusions (5) is in the range 0.2 to 0.5 mm.
